Europäisches Patentamt

European Patent Office

Office européen des brevets

(11) Publication number: **0 073 639**
**A2**

(12) # EUROPEAN PATENT APPLICATION

(21) Application number: **82304467.2**

(22) Date of filing: **24.08.82**

(51) Int. Cl.³: **H 01 L 31/06**

(30) Priority: **28.08.81 GB 8126342**

(43) Date of publication of application: **09.03.83**
**Bulletin 83/10**

(84) Designated Contracting States: **BE DE FR GB IT LU**

(71) Applicant: **EUROPEAN ATOMIC ENERGY COMMUNITY (EURATOM), Batiment Jean Monnet Plateau du Kirchberg Boîte Postale 1907, Luxembourg (LU)**

(72) Inventor: **Gissler, Wolfram, Via delle Volpi 8, Cerro Di Laveno Varese 21014 (IT)**
Inventor: **McEvoy, Augustine Joseph, 63 Via Alberto Ranco, Varese (IT)**

(74) Representative: **Baverstock, Michael George Douglas et al, BOULT, WADE & TENNANT 27 Furnival Street, London, EC4A 1PQ (GB)**

(54) **Photovoltaic Schottky-barrier elements.**

(57) A photovoltaic Schottky-barrier element comprising a semiconductor substrate carrying a ruthenium dioxide layer as the metallic contact thereof. A solar cell and a photochemical cell are also described comprising, as the photovoltaic element or electrode, respectively, thereof, a photovoltaic Schottky-barrier element of the present invention.

EP 0 073 639 A2

PHOTOVOLTAIC SCHOTTKY-BARRIER ELEMENTS

The present invention relates to photovoltaic Schottky-barrier elements using ruthenium dioxide as the metallic contact thereof.

Known photovoltaic structures include: homojunctions, i.e. p-n [1] devices within a single semiconductor material; heterojunctions between differing semiconductors [2]. Schottky barrier structures with metal contacts on semiconductors [3] ; or degenerate semiconductors on semiconductor [4] (ITO on GaAs or Si). Also a metal oxide with metallic conductivity has been identified [5] , namely ruthenium dioxide.

Recently it has been reported [6] that ultrafine deposits of Pt and $RuO_2$ on colloidal particles of CdS inhibit photocorrosion and catalyze water photoelectrolysis. CdS is an n-type semiconductor with a band gap energy of 2.4 eV corresponding to a light wavelength of 517 nm. Contrary to the behaviour of other semiconductor electrodes (e.g. $TiO_2$), CdS electrodes do not oxidize water under illumination but are subjected themselves to a photocorrosion process, whereby sulphide ions are rapidly oxidized to sulphur [7]. This corrosion reaction can be prevented if a reducing agent (e.g. polysulphide) is added to the electrolyte [8]. The photocorrosion inhibiting, and specifically water oxidizing effect observed in the microheterogeneous CdS system is due to the presence of $RuO_2$ whereas Pt is known to catalyze specifically the hydrogen evolution reaction. If the water photoelectrolysis process of the microheterogeneous CdS system is explained by the model of a microelectro-chemical cell [6], the question arises whether the stabilizing ability of $RuO_2$ can be also exploited in a macroscopic photoelectrochemical cell consisting of a CdS electrode covered by a thin $RuO_2$ film and a Pt counter electrode.

It has now been found that a photovoltaic Schottky-barrier effect can be obtained with $RuO_2$ overlayers on CdS electrodes. We have not been able to reproduce all the results obtained with the known colloidal particles; in particular, hydrogen evolution could not be observed.

In accordance with the present invention there is provided a photovoltaic Schottky-barrier element comprising a semiconductor substrate carrying a ruthenium dioxide layer as the metallic contact thereof.

Preferably the substrate is cadmium sulphide and the ruthenium dioxide layer has been applied to the substrate by spluttering.

The element may be constructed with, on the side of the substrate opposite to that side on which the ruthenium dioxide layer is carried, at least one Ohmic contact, preferably of indium.

The present invention also provides a solar cell and a photochemical cell comprising, as the photovoltaic element or electrode, respectively, thereof, a photovoltaic Schottky-barrier element of the present invention.

The present invention will now be described, by way of example, with reference to the accompanying drawings, in which:-

Figure 1 shows the relaxation of "dark" current with time for a photovoltaic Schottky-barrier element of the present invention, following the application of a voltage pulse;

Figure 2 shows the element's dependence of current on voltage for the dark and illuminated electrodes at pH 12 under quasi-steady state conditions; curve (a) being for a CdS electrode with a 500 $\overset{\text{o}}{\text{A}}$ $RuO_2$ overlayer, and curve (b) being for a bare CdS electrode;

Figure 3 shows the current/voltage characteristics for a continuous potential sweep of CdS electrodes with 2000 $\overset{o}{A}$ RuO$_2$ overlayers; at pH 12; curve (a) being before "breakdown"; and curve (b) being after "breakdown";

Figure 4 are the Mott-Schottky plots for (a) a bare CdS electrode, and (b) a CdS electrode with 500 $\overset{o}{A}$ RuO$_2$ overlayer at pH 12;

Figure 5 shows the current/voltage characteristics of an electrochemical solar cell of the type Pt/0.2 m Na2504/RuO$_2$-CdS cell;

Figure 6 shows the element's current characteristic at a fixed potential of 0.2 V(SCE), in the presence of solvated oxygen in the electrolyte;

Figure 7 shows in a corrosion experiment, the plot of the concentration of Cd$^{++}$ experimentally determined in the electrolyte vs. the concentration of Cd$^{++}$ calculated on the basis of charge passed assuming 100% corrosion;

Figures 8a and (b) shows, for a solid state Schottky-barrier CdS/RuO$_2$ solar cell; (a) its current/voltage characteristic in darkness and under illumination, and (b) its Mott-Schottky relationship;

Figure 9 shows diagrammatically the structure of a solar cell having a Schottky-barrier at the interface between the semiconductor and the ruthenium dioxide layers; and

Figure 10 shows the spectral response of the solar cell of Figure 9.

CdS single crystals of 10 mm diameter and 2mm thickness with the 111-face (Cd atoms) exposed to the electrolyte were used experimentally. The donor density was $10^{15}$ $cm^{-3}$. Before film deposition, the crystals were polished mechanically by using diamond powder of 1 $\mu$m and then etched for about 1 minute in concentrated HCl. Ohmic back contacts were made by depositing indium at $400^{\circ}$C in a hydrogen atmosphere.

$RuO_2$ films were deposited by RF-sputtering by using a $RuO_2$ powder target. The sputtering process was performed in a pure Ar, a 50% $O_2$ gas mixture and a pure oxygen plasma. The sputtering rate was between 0.5 (pure Ar plasma) and 0.2 $\overset{o}{A}$/s (pure oxygen plasma). Films of various thickness between 100 and 5000 $\overset{o}{A}$ were made. The chemical composition was analyzed by ESCA measurements. Films sputtered in oxygen plasma revealed the stoichiometric composition whereas films sputtered in the pure Ar plasma were slightly substoichiometric with respect to $O_2$.

The electrodes were mounted in Perspex holders and sealed with type 240-SB polymeric resin-based lacquer of Electro-Science Laboratories, Inc. The electrochemical measurements were performed in a single compartment cell with a calomel reference electrode and a Pt-black counter electrode. A PAR model 173 potentiostat was used in conjunction with a PAR model 175 programmer and a PAR model 186 lock-in amplifier. Illumination was from a 1000 W xenon lamp filtered by 10 cm of water. The light was interrupted by an Ealing model 22-8411 electrical shutter. With exception of the corrosion experiments, in all experiments the light level was kept at very low values of the order of a few milliwatts/$cm^2$ to avoid damage to the elctrodes by possible photocorrosion effects. The light intensity was measured by a Kipp + Zoen calibrated thermopile. As monochromator a Spex model Minimate was used. If not otherwise stated, light of 500 nm wavelength is used. Capacity was determined by superimposing on the potentiostatically-controlled d-c voltage an a-c voltage of 50 - 100 mV amplitude while measuring the amplitude change and phase shift caused by an external resistance inserted in series with the electrochemical cell.

All chemicals used were of Analar grade. Water was deionized and bidistilled. In all experiments, 0.2 M $Na_2SO_4$, adjusted to various pH values either by addition of NaOH or of $H_2SO_4$, was used as electrolyte.

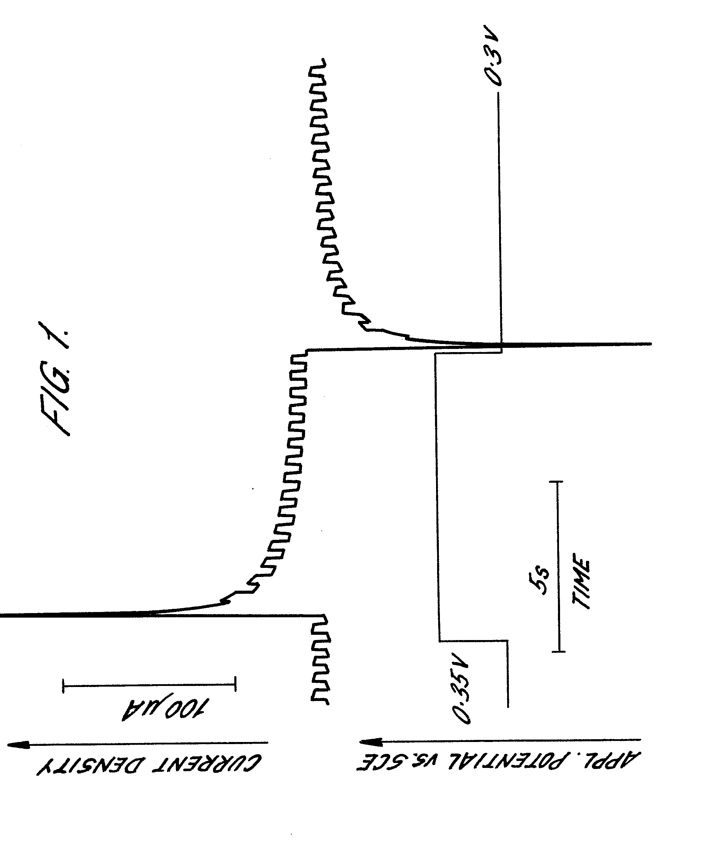

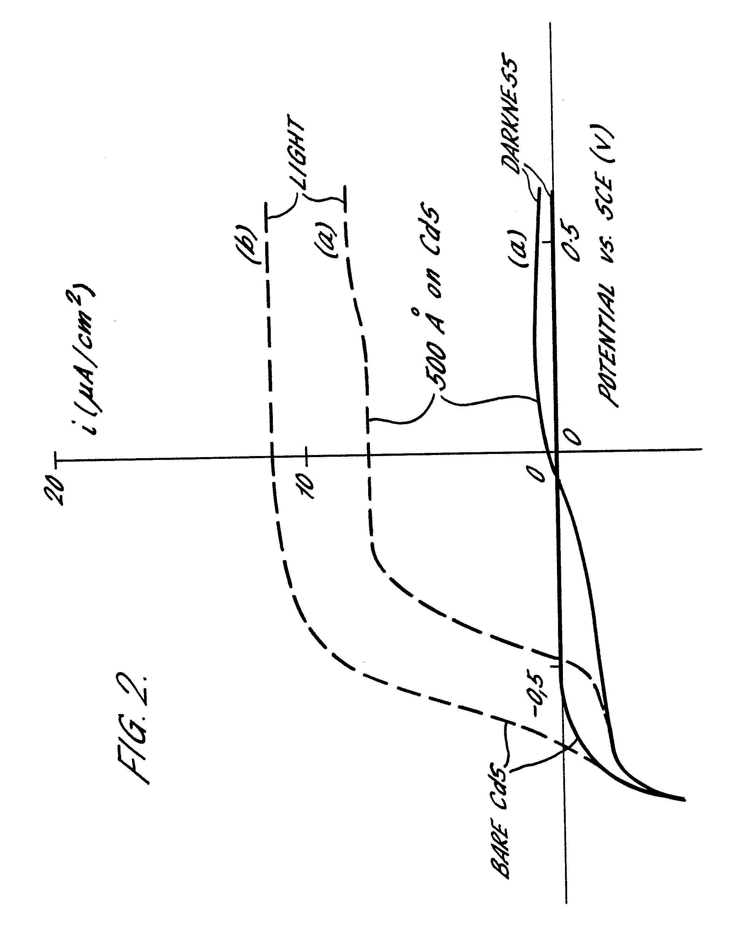

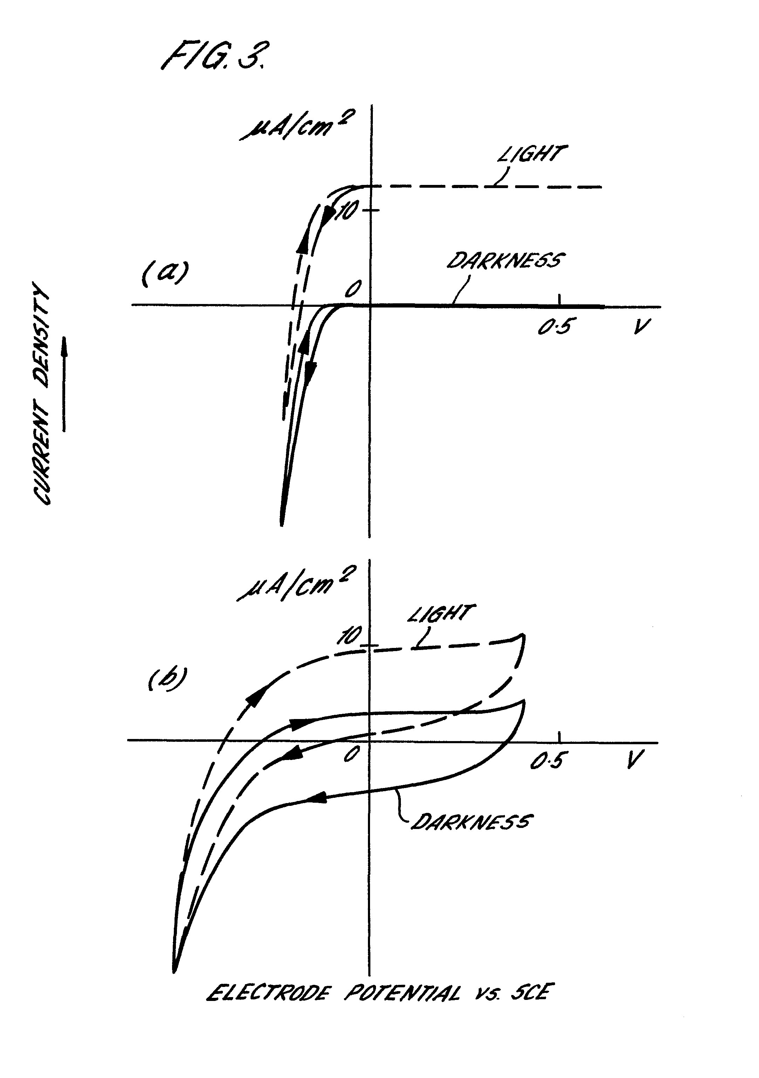

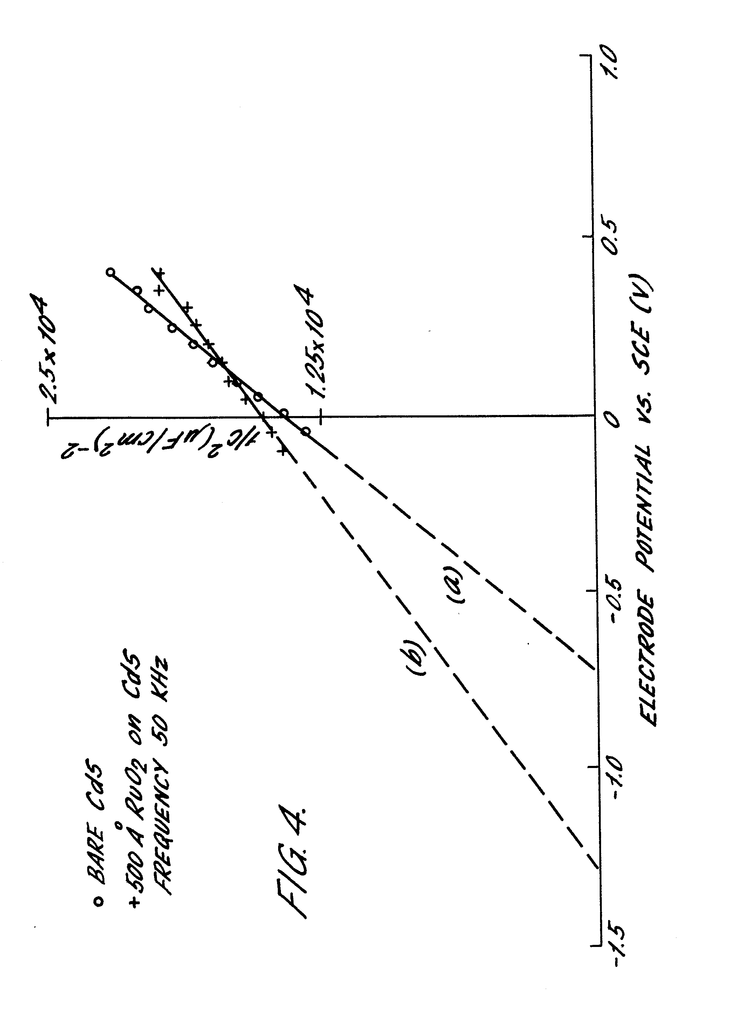

The current-potential characteristics of $RuO_2$-covered CdS electrodes were found to be subject to strong transient effects with relaxation times in the order of several minutes.  Figure 1  demonstrates this by a current-time plot of a CdS electrode covered with a 500 $\overset{o}{A}$ thick $RuO_2$ film.  The electrode was intermittently illuminated and a pulse of 0.2 to 0.4 V (SCE) was applied. It is interesting to note that only the dark current shows a transient behaviour whereas the photocurrent response remains prompt.  In order to eliminate the influence of these transients, the current-voltage dependence of Figure 2a was recorded in quasi-steady state conditions by applying the respective potential 8 minutes before measuring the current density.  Under this condition, the dark current decreased to a very low level and the i-V dependence assumed the typical behaviour of an n-type semiconductor electrode.  In comparison with the i-V dependence of the bare CdS electrode (Figure 2b), the photocurrent onset potential was shifted to more anodic values; and a cathodic dark current was observable already at potentials slightly cathodic of 0 V (SCE). The reduced sensitivity of the $RuO_2$-covered electrode was caused by strong light absorption in the $RuO_2$ layer. If the i-V dependence was measured by applying a continuous potential sweep however, curves of different shape depending on the film preparation and the initial potential setting were obtained.  Figures 3a and 3b show two characteristic examples obtained with about 2000 $\overset{\text{o}}{\text{A}}$ thick overlayers of $RuO_2$ on CdS electrodes, at a sweep rate of 10 mV/s at pH 12. In some cases a breakdown effect was observed if the potential exceeded a value of about 0.5 V (SCE). In these cases the originally observed i-V dependence of the type shown in Figure 3a, was modified to that shown in Figure 3b. It should be noted that in these cases the photoresponse was not affected; the breakdown phenomenon being observed in the "dark" characteristics.

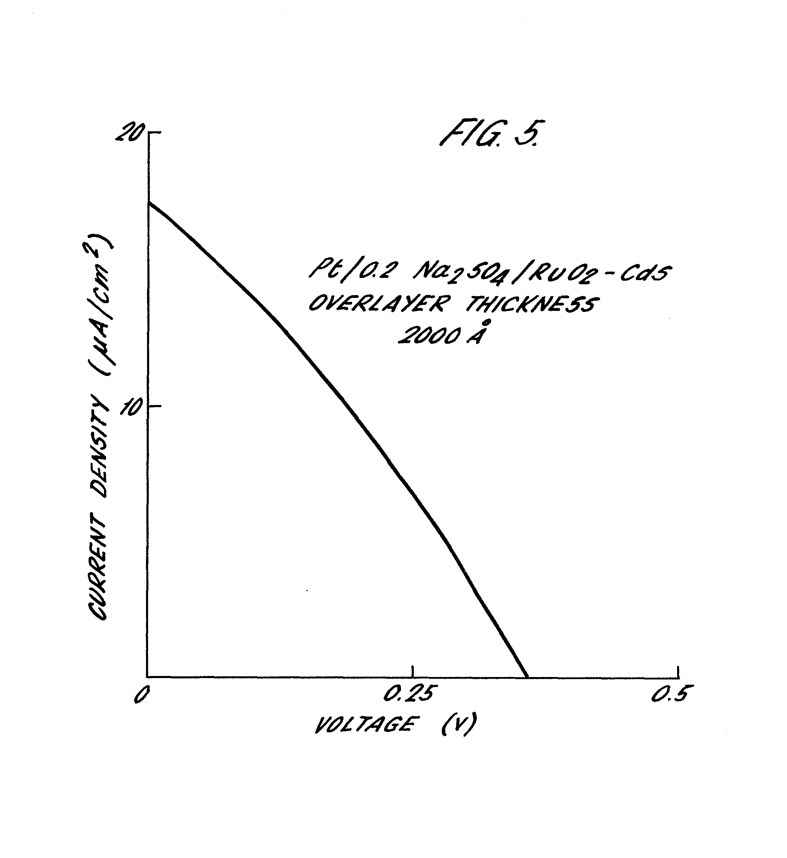

The dependence of the capacity of the space charge layer ($C_{sc}$) on the electrode potential was measured, at pH 12 using a modulation frequency of 50 kHz, in a potential range where the dark current density was smaller than 1 $\mu A/cm^2$. At lower modulation frequencies, dispersion was observed. In order to obtain linear Mott-Schottky plots ($C_{sc}^{-2}$ vs V), it was necessary to maintain a constant electrode potential for several minutes before measuring the capacities. Figure 4 shows the result for a CdS electrode covered with a 500 $\overset{\text{o}}{\text{A}}$ thick overlayer of $RuO_2$ in comparison with a blank CdS electrode. The effect of the $RuO_2$ overlayer is evidently to shift the flat band potential by 0.5 V to a value of U = 0.7 V, which is anodic of the hydrogen evolution potential. The different slopes of both curves indicate also a change in the charge carrier density from $1.4 \times 10^{15}$ $cm^{-3}$ for the blank to $0.9 \times 10^{14}$ $cm^{-3}$ for the film-covered electrode.

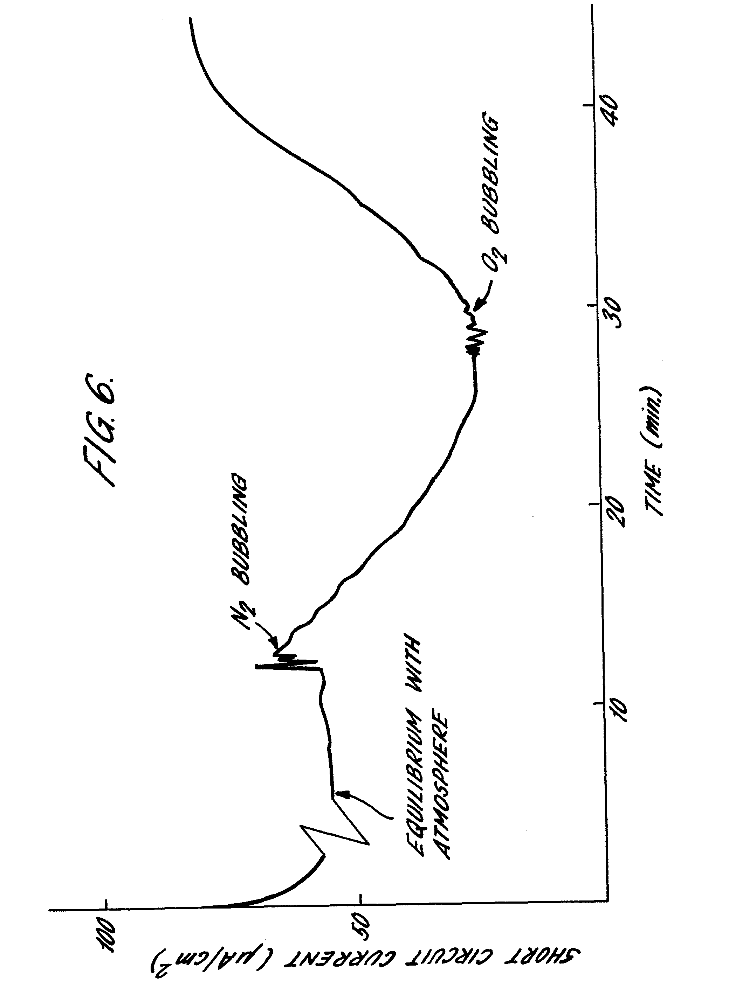

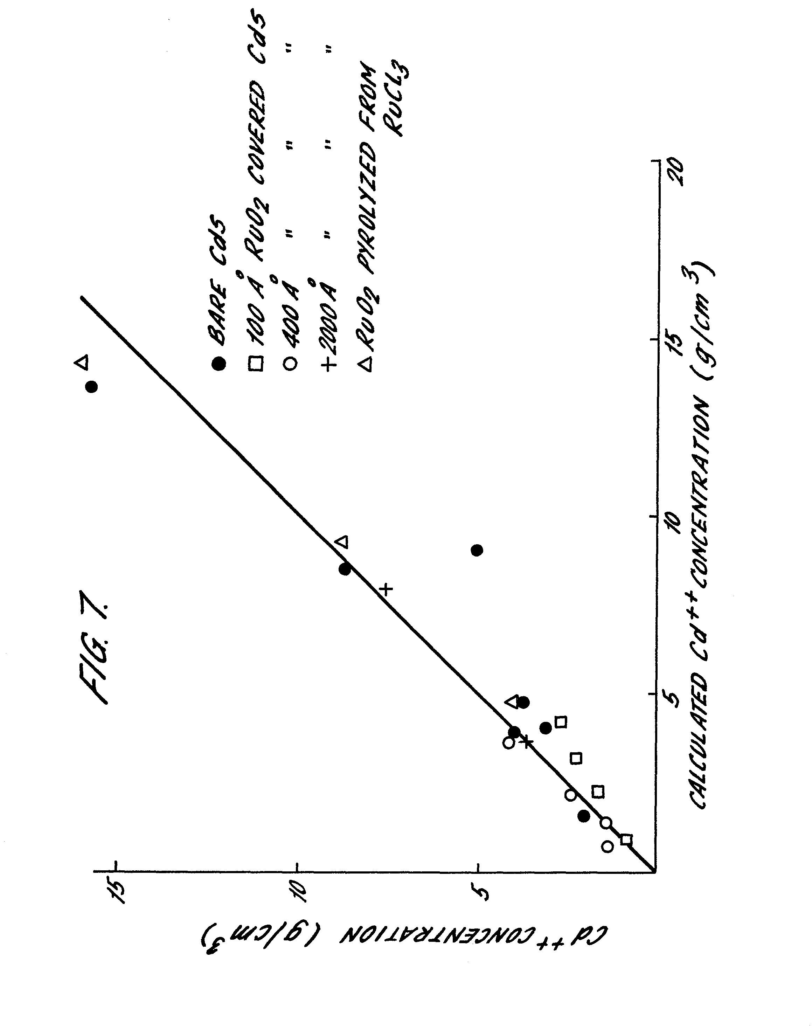

An electrochemical solar cell has been made by connecting the semiconductor with the counter electrode in series with a variable resistive load. Figure 5 compares the power characteristic obtained with and without a $RuO_2$ overlayer on the CdS electrode at pH 7, using intermittent light of 500 nm wavelength. Both short circuit current ($i_{sc}$) and open circuit voltage ($V_{oc}$) are smaller for the film-covered electrode. $V_{oc}$ is only 0.3 V. Figure 6 shows the time (t) dependence of $i_{sc}$ for the same film-covered electrode. For ten minutes the electrolyte was exposed to air; then $N_2$ was bubbled for a further ten minutes; finally $O_2$ was bubbled through the electrolyte. $N_2$ bubbling diminished $i_{sc}$ and $O_2$ bubbling had the contrary effect. This behaviour suggests that the interfacial cathodic reaction is oxygen reduction rather than the hydrogen evolution observed with the microheterogeneous system 6 .

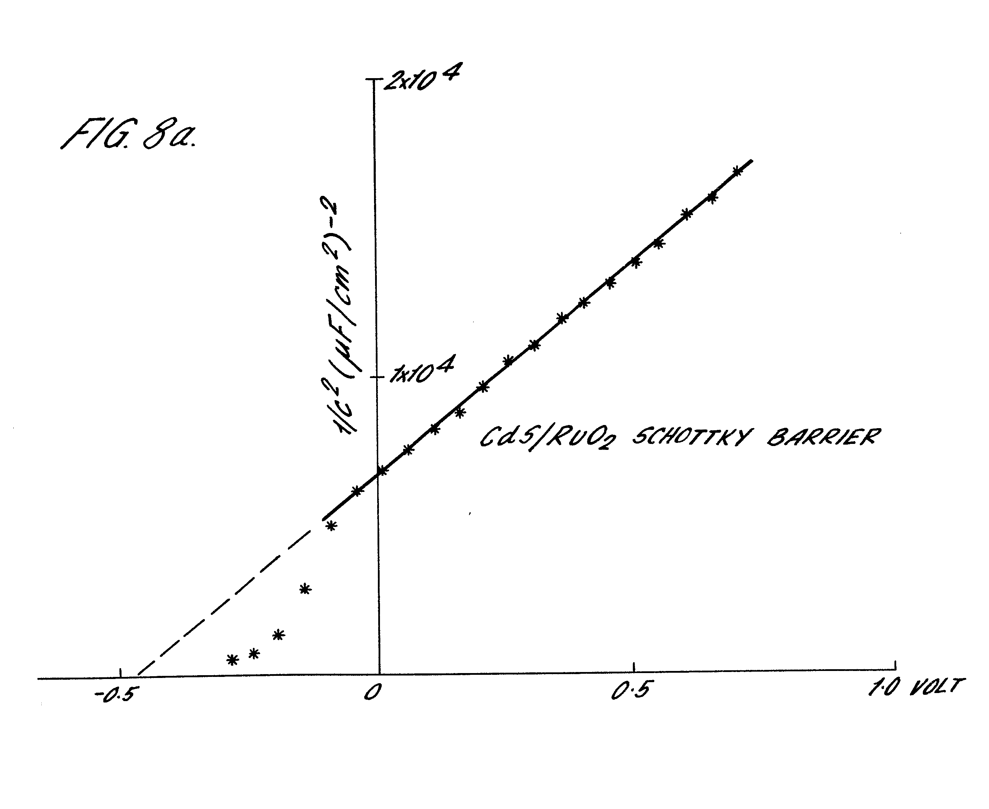

A series of corrosion tests has been performed by analyzing samples of the electrolyte for dissolved $Cd^{++}$ ions by atomic absorption spectroscopy. Figure 7 shows the concentration of cadmium experimentally determined in the electrolyte as a function of the concentration of
cadmium calculated on the basis of charge passed through
the cell.  In all cases the light level was regulated
so that the current density did not exceed 200 $\mu A/cm^2$;
the potential was adjusted to 0.2 V (SCE).  Only at
pH 12 was a corrosion-inhibiting effect indicated; however,
in this alkaline electrolyte the ionic solubility of
cadmium is known to be low, so that any conclusion must
be qualified.  A close inspection of the electrode surface
by optical and scanning electron microscopy after this
corrosion experiment revealed an inhomogeneous deposit
of sulphur; it is suggested that corrosion is initiated
at the ruthenium dioxide film defects (pinholes or
microcracks) which allow direct contact of the
electrolyte to the CdS crystal.

It has been shown (Figure 1)  that the photocurrent
of a $RuO_2$-covered CdS electrode is essentially independent
of the dark current transient behaviour.  Furthermore, the
photocurrent of different electrodes behaves very
similarly in spite of the fact that dark currents
are subjected to considerable changes (Figure 3).  These
observations suggest that dark and photocurrent behaviour
are not interrelated, differing from the usual case for a
semiconductor electrolyte junction.  A possible explanation
is to consider the $RuO_2$-covered CdS electrode as being composed of a photoelectrochemically-inactive electrolyte/ $RuO_2$ junction and series-connected photo-active $RuO_2$/CdS Schottky-barrier. A similar model was proposed by Harris and Coworkers [9] to explain the role of metal overlayers on gap electrodes. However, a Schottky-barrier at the $RuO_2$ interface can only be formed if $RuO_2$ exhibits metallic conductivity: that this is actually the case has been shown by Lodi and Coworkers [10] from the temperature dependence of the conductivity, and recently by Riga and Coworkers [11] by an investigation of the electronic structure with the Esca method. It turned out that the metal-like character is due to a partially filled 4D band at the fermi level.

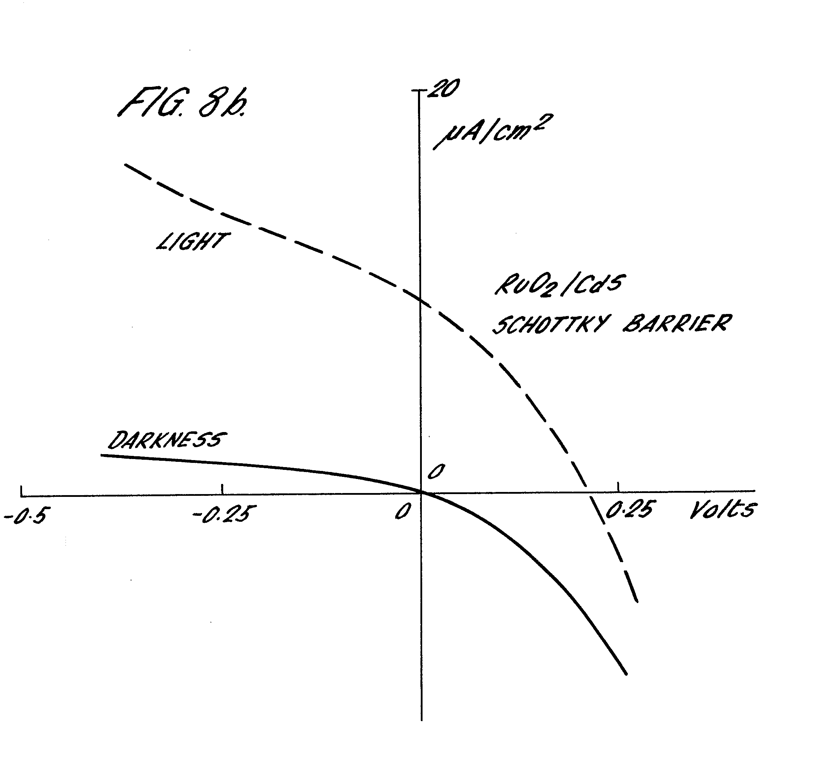

To support our hypothesis, we investigated more closely the i-v dependence and the Mott-Schottky characteristic of a solid state $RuO_2$/CdS junction. Figures 8a and b show the results obtained with a $RuO_2$ overlayer of 1500 A thickness. The junction is actually photoactive and shows a i-v dependence which is characteristic for a "leaky" diode with an open circuit voltage Voc of 0.3 V. This value is in agreement with Voc obtained with the electrochemical cell (Figure 5). The Mott-Schottky plot of the space charge layer capacity shows a linear behaviour from which is Schottky-barrier height of ECB = 0.5 V is derived. This value compares well with Voc considering the relatively low illumination level at the depth of the Schottky-barrier due to absorption in the overlayer.

The dark current behaviour of a $RuO_2$ electrode has been investigated by Lodi and Coworkers [12]. It is characterized by a strong oxidation-reduction wave similar to that displayed in Figure 3b. Also strong transient currents with relaxation times of several minutes have been observed. Considering that our $RuO_2$/ CdS diode is "leaky", this dark current behaviour might easily be displayed in the whole potential range as observed in Figure 3b. If the diode, however, shows a blocking behaviour, then the characteristic observed in Figure 3a is expected. We assume that the different i-V curves are essentially due to an uncontrolled diode characteristic. In particular, the "breakdown" effect is localized at the Schottky interface.

A photocorrosion-inhibiting effect of the $RuO_2$ overlayer is an expected consequence of the proposed model. With a fully homogeneous film, corrosion should be completely suppressed. It has been noted that corrosion is initiated at film defects. Subsequently it is assumed that current at the defects sites dominated, with, as a consequence, the continued photocorrosion observed.

Assuming, however, that the $RuO_2$ film protects the

CdS crystal from direct contact with the electrolyte, we must consider the charge transfer mechanism in the $RuO_2$ layer. With metallic conductivity in this oxide, photoexcited holes from the semiconductor injected across the Schottky-barrier, would be expected to recombine rapidly. In this case, the maximum cell voltage is equal to the height of the Schottky-barrier of O.5 V. Photoelectrolytic water decomposition is not, therefore, to be expected. The anodic interfacial reaction is supposed to be the oxygen evolution to which a transient proton absorption process as proposed for the $RuO_2$ electrode [10] might be superimposed. For the cathodic reaction at the Pt counter electrode, the oxygen reduction reaction is suggested.

The question arises why water photoelectrolysis occurs in the microheterogeneous system and not in a macroscopic electrochemical cell of the type investigated. Several reasons might be responsible for this discrepancy:- (i) the increasing influence of surface states with decreasing partizle size might change the nature of the $RuO_2$/CdS junction (ii) ultra thin $RuO_2$ films - as supposed to cover the colloidal particles [6] - can have different properties than regularly formed $RuO_2$ crystals. Actually it is known from experimental and theoretical studies 13, 14 that small changes of the lattice geometry can cause a metal-semiconductor transition. Semiconducting properties of the $RuO_2$ film could better explain the supposed [6] hole transfer properties; (iii) it is expected that the influence of attached hydroxyl groups is larger in the microheterogeneous systems than for an homogeneously covered macroscopic electrode. The importance of hydroxyl groups for the catalytic properties of $RuO_2$ has been mentioned [15].

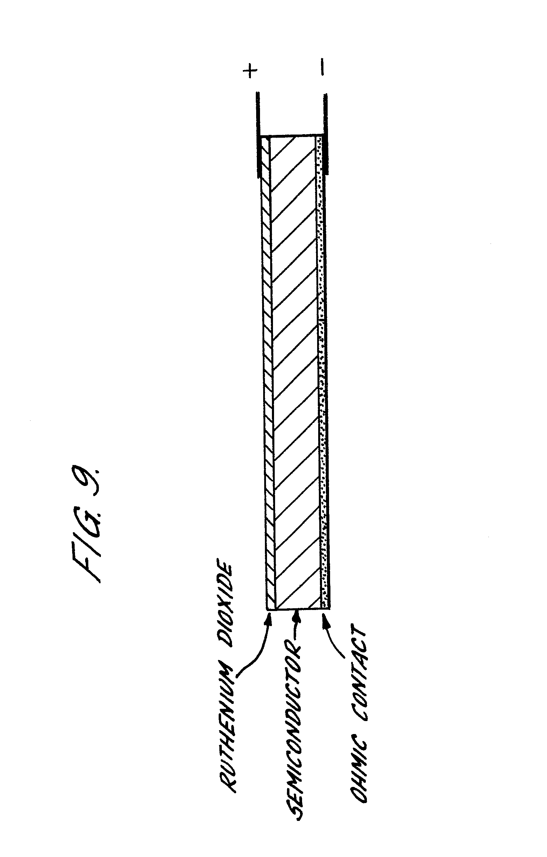

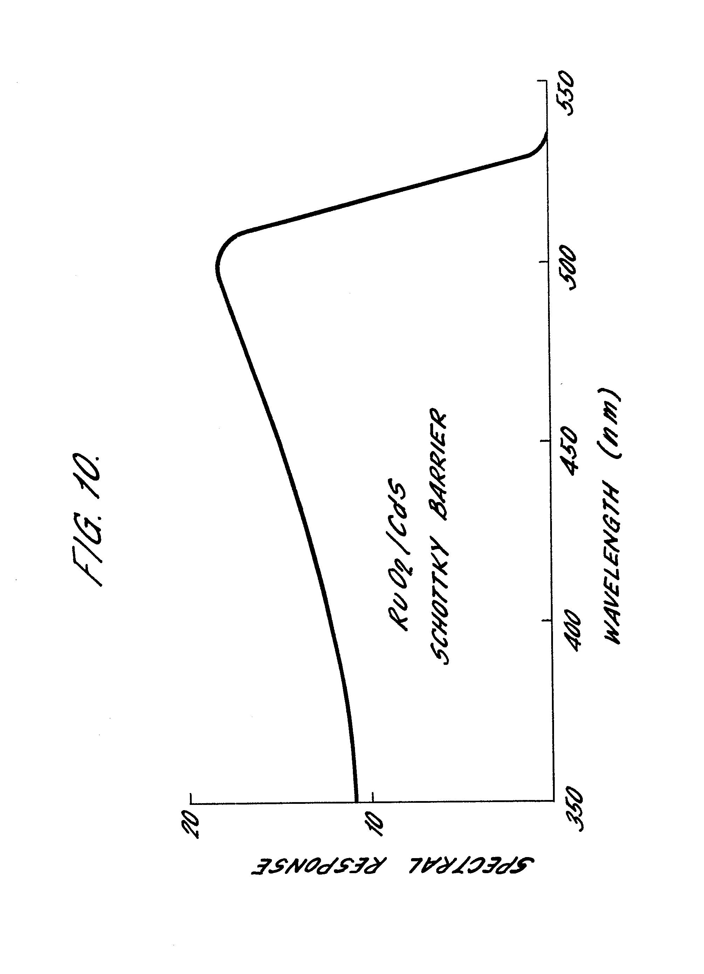

In Figure 9, the structure of a solar cell is diagrammatically shown in which a Schottky-barrier has been established at the interface between the semiconductor and the ruthenium dioxide layers. Indium is preferably used as the Ohmic contact, and Figure 10 shows the spectral response of such a solar cell showing a cut-off at 530 nm, which is indicative of the cell operating by optical absorption and carrier formation in the semiconductor, in this case CdS.

References:

[1]   Siliconhomojunction cell : Fischer, H., Festkörper-
      probleme XIV (1974), P. 153; Buhs, R., Nagel G.,
      and Wegmann, H.D., and E.C. Photovoltaic Solar
      Energy Conf. Berlin, April 1979 : Reidel, Dordrecht,
      1979, P. 237

[2] CdS-Cu$_2$S cell : Pfsiterer F. Hewig G.H., Schock H.W., and EC Photovaltaix Solar Energy Conf. Berlin, April, 1979, P. 352

[3] GaAs Schottky barrier :Van Meirhaeghe R.L., Verspurten E.S., Carden F., Gomes W.P., 2nd EC P-V S.E. Conf. P. 946

[4] Indium-tin oxide/silicon cell : Schewchun, J., Proc. Photovoltaics Program Semilannual Rev., Adv. Mater. R.D. Branch 1977 (Publ. 1978) NTIS, Springfield Va. (USA)

[5] Riga J., Tenret-Noel, C., Pirieux J.J., Caudano R., and Verbist J.J., Physica Scripta, 16, 351, 1977

[6] K. Kalyanasundaram, E. Borgarello and M. Grätzel, Helv. Chim. Acta, 64, 361, 1981

[7] R.Williams, J. Chem. Phys., 32, 1505, 1960

[8] A.B. Ellis, S.W. Kaiser and M.S. Wrighton, J. Am. Chem. Soc., 96, 1635, 1976

[9]  L.A. Harris, M.E. Gerstner and R.H. Wilson, J. Electrochem. Soc. 124, 1511, 1977

[10]  G. Lodi, G. Zucchini, A. de Battisti, E. Sivieri and S. Trasatti, Materials Chemistry 3, 179, 1978

[11]  J. Riga, C. Tenvet-Noel, J.J. Pireaux, R. Caudano and J.J. Verbist, Physica Scripta, 16, 351, 1977

[12]  G. Lodi, A. Sivieri, A. de Battisti and S. Trasatti, J. Appl. Electrochem., 8, 135, 1978

[13]  N. Beatham and A.F. Orehard, J. Electron Spectrox, Relat. Phenom., 16, 77, 1979

[14]  J.B. Goodenough, Progs. Solid State Chem.,

5, 145, 1977

[15]  S. Trasatti and W. E. O'Craill, W.,

Eleckochem. Series.

CLAIMS:

1.  A photovoltaic Schottky-barrier element comprising a semiconductor substrate carrying a ruthenium dioxide layer  as the metallic contact thereof.

2.  An element as claimed in claim 1 wherein the substrate is cadmium sulphide.

3.  An element as claimed in claim 1 or claim 2 wherein the ruthenium/dioxide layer has been applied to the substrate by spluttering.

4.  An element as claimed in any one of the preceding claims and including, on the side of the substrate opposite to that side on which the ruthenium dioxide layer is carried, at least one Ohmic contact.

5.  An element as claimed in claim 4 wherein the Ohmic contact comprises indium.

6.  An element as claimed in claim 1 substantially as hereinbefore described with reference to the accompanying drawings.

7. A solar cell comprising, as the photovoltaic element thereof, an element as claimed in any one of the preceding claims.

8. A photochemical cell comprising, as a photovoltaic electrode thereof, an element as claimed in any one of claims 1 to 6.

9. A solar cell as claimed in claim 7 substantially as hereinbefore described with reference to and as illustrated in Figure 9 of the accompanying drawings.

MGB/SJW/DR/BA3097

FIG. 1.

CURRENT DENSITY

100μA

APPL. POTENTIAL vs. SCE

0·35V

0·3V

5s

TIME

1/1

0073639

FIG. 2.

FIG. 3.

(a)

(b)

ELECTRODE POTENTIAL vs. SCE

FIG. 4.

o BARE CdS

+ 500 Å RuO₂ on CdS

FREQUENCY 50 KHz

$1/C^2 (\mu F/cm^2)^{-2}$

$2.5 \times 10^4$

$1.25 \times 10^4$

ELECTRODE POTENTIAL VS. SCE (V)

(a)

(b)

-1.5   -1.0   -0.5   0   0.5   1.0

FIG. 5.

Pt / 0.2 Na₂SO₄ / RuO₂ - CdS
OVERLAYER THICKNESS
2000 Å

CURRENT DENSITY ($\mu A/cm^2$)

VOLTAGE (V)

FIG.6.

FIG. 7.

Legend:
- ● BARE CdS
- □ 100 Å $RuO_2$ COVERED CdS
- ○ 400 Å    "         "          "
- + 2000 Å   "         "          "
- △ $RuO_2$ PYROLYZED FROM $RuCl_3$

Y-axis: $Cd^{++}$ CONCENTRATION $(g/cm^3)$

X-axis: CALCULATED $Cd^{++}$ CONCENTRATION $(g/cm^3)$

7/11

0073639

FIG. 8a.

CdS/RuO$_2$ SCHOTTKY BARRIER

$1/c^2(\mu F/cm^2)^{-2}$

$2\times10^4$

$1\times10^4$

-0.5    0    0.5    1.0 VOLT

FIG. 8b.

LIGHT

DARKNESS

$\mu A/cm^2$

$RuO_2/CdS$ SCHOTTKY BARRIER

Volts

-0.5    -0.25    0    0.25

20    0

# FIG. 9.

RUTHENIUM DIOXIDE

SEMICONDUCTOR

OHMIC CONTACT

+

−

10/11

0073639

FIG. 10.

RvO₂/CdS
SCHOTTKY BARRIER

SPECTRAL RESPONSE

WAVELENGTH (nm)